Europäisches Patentamt

European Patent Office

Office européen des brevets

(19)

(11) Veröffentlichungsnummer: **0 330 837 B1**

(12) **EUROPÄISCHE PATENTSCHRIFT**

(45) Veröffentlichungstag der Patentschrift: **04.11.92**

(51) Int. Cl.⁵: **H01S 3/043**, H01L 33/00

(21) Anmeldenummer: **89101291.6**

(22) Anmeldetag: **25.01.89**

(54) **Halbleiterlaserchip mit Wärmesenke.**

(30) Priorität: **01.03.88 DE 3806571**

(43) Veröffentlichungstag der Anmeldung:
**06.09.89 Patentblatt 89/36**

(45) Bekanntmachung des Hinweises auf die
Patenterteilung:
**04.11.92 Patentblatt 92/45**

(84) Benannte Vertragsstaaten:
**DE FR GB**

(56) Entgegenhaltungen:
**US-A- 3 946 334**
**US-A- 4 210 878**
**US-A- 4 675 074**

**IEEE JOURNAL OF OUANTUM ELECTRONICS,
Band OE-20, Nr. 11, November 1984, Seiten
1277-1283, IEEE, New York, US; E.M. GARMIRE
et al.: "Heatsink requirements for coherent
operation of high-power semiconductor laser arrays"**

(73) Patentinhaber: **SIEMENS AKTIENGESELL-
SCHAFT**
**Wittelsbacherplatz 2**
**W-8000 München 2(DE)**

(72) Erfinder: **Westermeier, Heinz, Dipl.-Ing. (FH)**
**Josef-Kyrein-Strasse 9 c**
**W-8014 Neubiberg(DE)**

## Beschreibung

Halbleiterlaserchips werden auf Platinen oder in Gehäusen montiert, die neben der Halterung des Chips gleichzeitig der Ableitung der im Betrieb entstehenden Wärme dienen. Zu diesem Zweck müssen die für die Gehäuse verwendeten Materialien hinreichend hohe Wärmeleitfähigkeit besitzen. Die für die Montage des Chips vorgesehene Grundfläche des Chips ist in der Regel eben. Um eine optimale Wärmeableitung zu erzielen, soll der Chip nach Möglichkeit mit der gesamten Grundfläche auf dieser Gehäuseoberfläche aufliegen. Andererseits darf die Strahlungsausbreitung nicht durch überstehende Kanten des Gehäuses behindert werden. Wegen der bei der Herstellung auftretenden Schwierigkeit, den Halbleiterlaserchip so zu montieren, daß die Kante der Resonatorendfläche mit der Gehäusekante möglichst gut zusammenfällt, werden die Chips in der Regel so montiert, daß die Zone für den Austritt der Laserstrahlung der Montagefläche abgewendet zu liegen kommt. Die Beeinträchtigung der Strahlungsausbreitung kann so gering gehalten werden. Andererseits ist die Wärmeableitung nicht so gut, weil sich zwischen der laseraktiven Zone und der Wärmesenke dickere Schichten von Halbleitermaterial befinden.

Bei planarem Chipaufbau ist grundsätzlich eine Montage in umgekehrter Richtung (upside down) möglich; wegen der dann möglichen Störung des Strahlaustrittes ist die Ausbeute an funktionstüchtigen Laserchips jedoch vermindert. Besonders schwierig ist es, die Lage der Laserresonatorendkante und die Kante der Wärmesenke bei Lasern mit geätzten Spiegelflächen in Übereinstimmung zu bringen.

Halbleiterlaser mit Resonatorspiegelendflächen, die durch planartechnisches Ätzen hergestellt sind, sind in US-A-4 675 074 beschrieben.

Aufgabe der vorliegenden Erfindung ist es, einen Aufbau für einen Halbleiterlaserchip mit Wärmesenke anzugeben, bei dem das Problem der Ausrichtung der Laserresonatorendkante und der Endkante der Wärmesenke zueinander nicht auftritt.

Diese Aufgabe wird mit dem erfindungsgemäßen Aufbau mit den Merkmalen des Anspruches 1 gelöst.

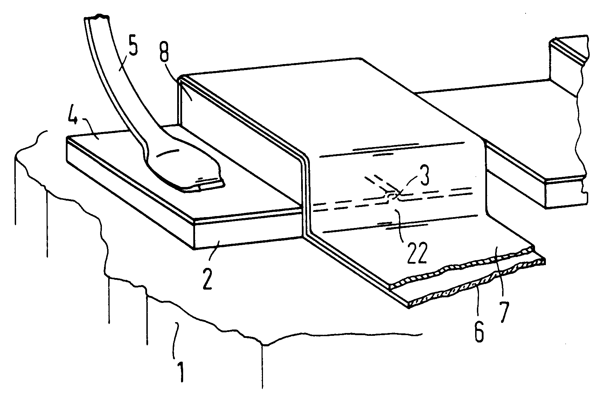

Es folgt die Beschreibung der Erfindung anhand der Figur.

Auf einem Substrat 1 aus Halbleitermaterial ist eine für Halbleiterlaser übliche Schichtfolge 2 aus Halbleitermaterial aufgewachsen und ein laseraktiver Streifen 3 ausgebildet. Es ist ein Metallkontakt 4 mit einer hinreichend großen Kontaktierfläche zum Anbringen des Bonddrahtes 5 vorgesehen. Die Resonatorspiegelendflächen 22 sind durch planartechnische Ätzung hergestellt, wobei eine auf der Oberfläche der Anordnung wie üblich aufgebrachte Ätzmaske Verwendung findet. Diese Ätzmaske wird aus einem Material hergestellt, das mindestens die Wärmeleitfähigkeit des darunter befindlichen Halbleitermaterials besitzt. Als Materialien kommen z.B. Kohle oder Silizium in Frage.

Diese Ätzmaske verbleibt erfindungsgemäß nach dem Ätzen der Resonatorspiegelendflächen 22 ganz oder teilweise auf der Oberfläche des Bauelementes. Die Ätzmaske verbleibt mindestens in dem von dem Resonator 3 des Lasers eingenommenen Bereich, und zwar dort bis zu den Kanten der Resonatorspiegelendflächen 22, und dient als Wärmesenke 8, deren Endflächen mit den Resonatorspiegelendflächen 22 des Laserresonators zusammenfallen. Auf diese Weise entfällt bei der Erfindung die Notwendigkeit einer genauen Montage des Laserchips auf einer externen Wärmesenke. Die Resonatorspiegelendflächen 22 und die Wärmesenke 8 können mit einer Spiegelpassivierung 6 aus z.B. $Al_2O_3$ und einem Reflexionsspiegelbelag 7 aus z.B. Silizium beschichtet sein. Die Dicke der Ätzmaske wird zweckmäßig zwischen etwa 5 $\mu$m und 10 $\mu$m gewählt. Es wird auf diese Weise eine ideale Abführung der im Betrieb entstehenden Wärme ohne Beeinträchtigung der Strahlungsausbreitung ermöglicht. Für die Befestigung des Laserchips in einem Gehäuse stehen beide großflächigen Oberflächen des Chips zur Verfügung.

## Patentansprüche

1. Anordnung eines Halbleiterlaserchips und einer zugehörigen Wärmesenke, wobei die Resonatorspiegelendflächen unter Verwendung einer Ätzmaske durch planartechnische Ätzung hergestellt sind, **dadurch gekennzeichnet,** daß mindestens ein Teil der für die Ätzung verwendeten Ätzmaske im Bereich des Resonators (3) des Lasers und dort bis an die Kante der für Lichtaustritt vorgesehenen Resonatorspiegelendfläche (22) reichend als Wärmesenke (8) ausgebildet ist und daß diese Wärmesenke (8) aus einem Material besteht, das mindestens die Wärmeleitfähigkeit des Halbleitermaterials der Schichtfolge (2) des Lasers aufweist.

2. Anordnung nach Anspruch 1, **dadurch gekennzeichnet,** daß die Dicke der Wärmesenke (8) zwischen 2 $\mu$m und 10 $\mu$m beträgt.

3. Anordnung nach Anspruch 1 oder 2, **dadurch gekennzeichnet,** daß die Wärmesenke (8) aus Silizium besteht.

**4.** Anordnung nach Anspruch 1 oder 2,
**dadurch gekennzeichnet,**
daß die Wärmesenke (8) aus Kohle besteht.

## Claims

**1.** Arrangement of a semiconductor laser chip and an associated heat sink, in which the resonator mirror end faces have been produced using an etching mask by planar technology etching, characterised in that at least one part of the etching mask used for the etching is constructed as a heat sink (8) in the region of the laser resonator (3) and extending from that point up to the edge of the resonator mirror end face (22) provided for the emergence of light, and in that said heat sink (8) consists of a material which has at least the thermal conductivity of the semiconductor material of the layer sequence (2) of the laser.

**2.** Arrangement according to Claim 1, characterised in that the thickness of the heat sink (8) is between 2 $\mu$m and 10 $\mu$m.

**3.** Arrangement according to Claim 1 or 2, characterised in that the heat sink (8) consists of silicon.

**4.** Arrangement according to Claim 1 or 2, characterised in that the heat sink (8) consists of carbon.

## Revendications

**1.** Ensemble formé d'une microplaquette à laser à semiconducteurs et d'un dissipateur thermique associé, les surfaces d'extrémité des miroirs du résonateur étant réalisées, moyennant l'utilisation d'un masque de corrosion, par une corrosion exécutée selon la technique planar, caractérisé par le fait qu'au moins une partie du masque de corrosion utilisé pour la corrosion est réalisée sous la forme d'un dissipateur thermique (8) qui s'étend dans la zone du résonateur (3) du laser et à partir de là jusqu'au bord de la surface d'extrémité (22) du miroir du résonateur, prévue pour la sortie de la lumière, et que ce dissipateur thermique (8) est réalisé en un matériau qui possède au moins la conductibilité thermique du matériau semiconducteur formé de la succession de couches (2) du laser.

**2.** Dispositif suivant la revendication 1, caractérisé par le fait que l'épaisseur du dissipateur thermique (8) est comprise entre 2 $\mu$m et 10 $\mu$m.

**3.** Dispositif suivant la revendication 1 ou 2, caractérisé par le fait que le dissipateur thermique (8) est réalisé en silicium.

**4.** Dispositif suivant la revendication 1 ou 2, caractérisé par le fait que le dissipateur thermique (8) est réalisé en carbone.